# EUROPÄISCHE PATENTSCHRIFT

(11) **EP 2 411 561 B1**
(45) Veröffentlichungstag und Bekanntmachung des Hinweises auf die Patenterteilung: **13.05.2020**
(21) Anmeldenummer: 10710311.1
(22) Anmeldetag: 22.03.2010
(51) Int. Cl.: C23C 28/04, C23C 28/00, C23C 30/00

(54) **PVD BESCHICHTETES WERKZEUG**
PVD-COATED TOOL
OUTIL REVÊTU PAR PVD

(30) Priorität: 23.03.2009 DE 102009001765
(43) Veröffentlichungstag der Anmeldung: 01.02.2012
(73) Patentinhaber: Walter AG, 72072 Tübingen (DE)
(72) Erfinder: SCHIER, Veit, 70771 Leinfelden-Echterdingen (DE); DROBNIEWSKI, Jörg, 71083 Herrenberg (DE)
(74) Vertreter: WSL Patentanwälte Partnerschaft mbB
(86) Internationale Anmeldenummer: PCT/EP2010/053714
(87) Internationale Veröffentlichungsnummer: WO 2010/108893

(56) Entgegenhaltungen:
- EP-A2- 1 762 637
- EP-A2- 1 762 638
- EP-A2- 1 997 938
- US-A1- 2004 033 393

## Beschreibung

Die Erfindung betrifft ein Schneidwerkzeug mit einem Grundkörper und einer darauf angebrachten mehrlagigen Beschichtung.

### Stand der Technik

Die zur Bearbeitung von harten Materialien, z.B. Stahl, eingesetzten Schneidwerkzeuge bestehen in der Regel aus einem Grundkörper, auf welchen zur Erhöhung der Standzeiten oder auch zur Verbesserung der Schneideigenschaften eine ein- oder mehrlagige Beschichtung aufgebracht wird. Für den Grundkörper verwendete Materialien sind beispielsweise Hartmetall, Cermet, Stahl oder Schnellarbeitsstahl. Die Beschichtungen umfassen häufig nitridische Verbindungen, aber auch metallische Hartstoffschichten, Oxidschichten und dergleichen. Zum Aufbringen der Beschichtung werden verschiedene Verfahren angewendet. Dazu gehören CVD-Verfahren (Chemical Vapour Deposition) und PVD-Verfahren (Physical Vapour Deposition).

Für bestimmte Anwendungen, wie z.B. das Fräsen von Kurbelwellen oder Nockenwellen, werden aufgrund der Materialeigenschaften des Werkstücks an die Werkzeuge besonders hohe Anforderungen gestellt. Bei der Herstellung von Kurbelwellen oder Nockenwellen werden in der Regel gegossene oder geschmiedete Wellen durch Fräsen weiter bearbeitet. Dabei sind die eingesetzten Kurbelwellenfräser oder Nockenwellenfräser hohen thermischen und mechanischen Wechselbeanspruchungen ausgesetzt. Die Standzeit der Werkzeuge wird dabei hauptsächlich durch eine Kombination aus Kammrissbildung und nachfolgendem Kolkverschleiß begrenzt, der an den Kammrissen beginnt.

Im Stand der Technik sind für Werkzeuge für die oben beschriebenen hohen thermischen und mechanischen Wechselbeanspruchungen CVD-beschichtete Werkzeugstähle bekannt, die jedoch aufgrund der hohen Beschichtungstemperatur Nachteile hinsichtlich der Kammrissfestigkeit aufweisen. Aufgrund des an den Kammrissen beginnenden Kolkverschleißes wird dadurch die an sich hohe Resistenz der CVD-beschichteten Werkzeugstähle gegenüber Kolkverschleiß relativiert.

Bei der Verwendung einer nitridischen Verbindung zur PVD-Beschichtung bekannter Werkzeugstähle ergibt sich Kolkbildung, die durch tribochemischen Verschleiß verursacht wird. Tribochemischer Verschleiß bedeutet dabei, dass an den Kontaktstellen zwischen Werkzeug und bearbeitetem Material bei der Bearbeitung Reibung auftritt, dies führt zu einer chemischen Reaktion, in deren Folge sich bearbeitetes Material und Werkzeugstahl chemisch und strukturell verändern, wodurch Verschleiß des Werkzeugs auftritt.

EP 1 762 637 und EP 1 762 638 offenbaren PVD beschichtete Werkzeuge. EP 1 997 938 und US2004/0033393 A1 offenbaren CVD beschichtete Werkzeuge.

### Aufgabe

Die Aufgabe der vorliegenden Erfindung bestand darin, gegenüber dem Stand der Technik verbesserte Schneidwerkzeuge bereitzustellen, die eine erhöhte Beständigkeit gegenüber Kammrissbildung, tribochemischem Verschleiß und dadurch bedingte Kolkbildung aufweisen.

Diese Aufgabe wird erfindungsgemäß durch ein Schneidwerkzeug mit einem Grundkörper und einer darauf aufgebrachten mehrlagigen Beschichtung gelöst, wobei der Grundkörper aus einem Hartmetall besteht, welches aus
- 5 bis 8 Gew.-% Co, 0 bis 2 Gew.-% TaC, 0 bis 1 Gew.-% NbC und 89 bis 95 Gew.-% WC mit einer mittleren Korngröße von 1 bis 5 µm besteht,
   und die Beschichtung
- eine erste Lage aus TiAIN mit einer Schichtdicke von 1 bis 5 µm und
- eine zweite Lage aus Aluminiumoxid mit einer Schichtdicke von 1 bis 4 µm aufweist, und die Beschichtung weiter auf der zweiten Lage aus Aluminiumoxid zusätzlich
- n alternierend übereinander aufgebrachte Lagen aus TiAIN und Lagen aus Aluminiumoxid mit jeweils einer Schichtdicke von 0,1 bis 0,5 µm umfasst, wobei n sich auf jede einzelne Lage bezieht und eine gerade Zahl von 0 bis 10 ist,
   wobei die Gesamtschichtdicke der Beschichtung 2 bis 16 µm beträgt und die Beschichtung im PVD-Verfahren erzeugt ist.

Die angegebene mittlere Korngröße bezieht sich auf das Wolframcarbid (WC). Überraschenderweise hat sich dabei gezeigt, dass die Kombination eines Hartmetalls mit den erfindungsgemäßen Gehalten an Co, TaC und NbC mit einer Beschichtung, die aus mindestens je einer Schicht TiAIN und Aluminiumoxid (Al₂O₃) besteht, wobei optional weitere Schichten aufgetragen werden, die alternierend ebenfalls aus TiAIN und Aluminiumoxid bestehen, besonders resistent gegenüber Kammrissbildung und daraus resultierendem Kolkverschleiß bei hohen thermischen und mechanischen Wechselbeanspruchungen ist.

Bei der erfindungsgemäßen Kombination des Grundkörpers und der Beschichtung gemäß Anspruch 1 hat sich herausgestellt, dass ein größerer Anteil an Cobalt im Grundkörper dazu führt, dass das Schneidwerkzeug zu weich ist. Ein Anteil an Cobalt von weniger als 5 Gew.-% führt zu einem mechanisch weniger belastbaren Schneidwerkzeug.

Die Anteile an NbC und TaC dienen der Einstellung des Gefüges und des gewünschten Verhältnisses von Härte und Zähigkeit.

Bei den weiteren Lagen versteht es sich, dass die auf der zweiten Lage aus Aluminiumoxid aufgebrachte Lage aus TiAIN besteht. Durch das alternierende Aufbringen einer geraden Anzahl an weiteren Lagen besteht damit die zuletzt aufgebrachte weitere Lage aus Aluminiumoxid.

In einer Ausführungsform der Erfindung weist die Beschichtung eine äußere Lage aus ZrN mit einer Schichtdicke von 0,1 bis 1 µm, vorzugsweise 0,1 bis 0,6 µm auf.

Der Vorteil einer äußeren Lage aus ZrN besteht darin, dass diese Lage im Vergleich zum Grundkörper und der Beschichtung aus TiAIN und Aluminiumoxid einen abweichenden Farbton aufweist. Bei der Benutzung des Schneidwerkzeugs erhalten die Freiflächen bedingt durch teilweises Abtragen der oberen Lage aus ZrN Verschleißspuren. Dadurch kann mit bloßem Auge festgestellt werden, ob eine Schneidkante bereits benutzt wurde.

Bevorzugt weist die Beschichtung unter der äußeren Lage aus ZrN eine Lage aus substöchiometrischem ZrN₁₋ₓ auf, wobei x 0,01 bis 0,1 beträgt und wobei die Schichtdicke der Lage zwischen 0,001 und 0,1 µm beträgt. Die Lage aus substöchiometrischem ZrN₁₋ₓ haftet weniger gut an der oberen Lage aus Aluminiumoxid als ZrN, so daß ein Entfernen der ZrN Lage zusammen mit der darunterliegenden ZrN₁₋ₓ -Lage vereinfacht wird. Dadurch treten Verschleißspuren bereits bei der ersten Verwendung des Schneidwerkzeugs auf, die darauf hinweisen, dass das Werkzeug nicht unbenutzt ist.

Schneidwerkzeuge besitzen Spanflächen, Schneidkanten und Freiflächen. Erfindungsgemäß bevorzugt umfasst nur die Beschichtung an den Freiflächen eine äußere Lage aus ZrN und optional eine Lage aus substöchiometrischem ZrN₁₋ₓ unter der äußeren Lage aus ZrN.

Die unterschiedlichen Beschichtungen entstehen dadurch, dass zunächst das gesamte Schneidwerkzeug mit ZrN beschichtet und anschließend die Lage aus ZrN vollständig durch Bürsten und/oder (Reinigungs-)Strahlen von der Spanfläche und in der Regel auch von der Schneidkante entfernt wird. Verbleibt die Lage aus ZrN an der Spanfläche des Schneidwerkzeugs, kann dies die Abführung der Späne beeinträchtigen. Das Entfernen wird durch das Aufbringen einer Lage aus substöchiometrischem ZrN₁₋ₓ unter der äußeren Lage aus ZrN ebenfalls vereinfacht, da die Lage aus substöchiometrischem ZrN₁₋ₓ weniger gut an einer Lage aus Aluminiumoxid haftet als die äußere Lage aus ZrN.

In einer besonders bevorzugten Ausführungsform besteht der Grundkörper aus einem Hartmetall, welches 6 bis 8 Gew.-% Co, 1 bis 2 Gew.-% TaC, 0,2 bis 0,3 Gew. % NbC und als Rest WC aufweist. Diese Zusammensetzung ist in Kombination mit den erfindungsgemäßen Beschichtungen besonders geeignet für hohe thermische und mechanische Wechselbeanspruchungen. Sie umfasst keine weiteren Hartstoffe.

Weiterhin bevorzugt ist es, dass das Wolframcarbid (WC) in dem erfindungsgemäßen Schneidwerkzeug eine mittlere Korngröße von 2 bis 3 µm aufweist. Die mittlere Korngröße von WC beeinflußt das Verhältnis von Härte und Zähigkeit. Eine größere mittlere Korngröße führt zwar zu größerer Härte, aber gleichzeitig wird die Zähigkeit stark verringert. Eine kleinere mittlere Korngröße bedingt zwar eine größere Zähigkeit, verursacht gleichzeitig aber auch einen geringen Härteverlust.

In einer anderen bevorzugten Ausführungsform weist die erste Lage aus TiAIN eine Schichtdicke von 2 bis 4 µm auf und/oder die zweite Lage aus Aluminiumoxid weist eine Schichtdicke von 1 bis 2 µm auf. Durch die Lage aus TiAIN mit der genannten Schichtdicke wird ein gewünschtes Verhältnis von Härte zu Zähigkeit eingestellt. Die Lage aus Aluminiumoxid mit der genannten Schichtdicke bedingt Hochtemperatur- und Oxidationsbeständigkeit und führt damit zu tribochemischer Verschleißfestigkeit.

In einer weiteren bevorzugten Ausführungsform umfaßt das Schneidwerkzeug eine Beschichtung, wobei die optionalen weiteren Lagen, die alternierend aus TiAIN bzw. Aluminiumoxid bestehen, eine Schichtdicke von 0,1 bis 0,3 µm aufweisen. Durch die weiteren Lagen weist die Beschichtung mehr Grenzflächen auf, was zu einer Steigerung der Zähigkeit führt, nicht jedoch der Härte.

Es ist weiter bevorzugt, dass für die zusätzlichen alternierenden Lagen aus TiAIN und Lagen aus Aluminiumoxid n = 2 oder n = 4 oder n = 6 ist. Eine höhere Anzahl der Lagen würde zwar zu einer Erhöhung der Zähigkeit führen. Andererseits weisen diese Lagen in der Regel eine Druckspannung auf. Eine größere Anzahl von Lagen würde daher möglicherweise zu einer instabilen Beschichtung führen, die abplatzt. Weiterhin ist das Aufbringen einer Vielzahl von alternierenden Schichten aus TiAIN bzw. Aluminiumoxid im PVD-Verfahren verfahrenstechnisch sehr aufwendig, so dass großtechnisch dadurch ebenfalls eine Grenze gesetzt ist.

Bevorzugt beträgt die Gesamtschichtdicke der Beschichtung 2 bis 8 µm. Eine dünnere Beschichtung würde nicht die ausreichende Anzahl an Atomschichten aufweisen, um einen guten Verschleißschutz darzustellen. Eine dickere Beschichtung wäre aufgrund von Druckverspannungen der einzelnen Lagen weniger stabil und würde möglicherweise insbesondere an den Kanten abplatzen.

Bevorzugt sind weiterhin Schneidwerkzeuge, bei welchen das Verhältnis von Al zu Ti in den aus TiAIN bestehenden Lagen von 60:40 bis 70:30 und bevorzugt 67:33 beträgt. Es handelt sich dabei um das atomare Verhältnis (at%). Dieses Verhältnis bedingt ein besonders gutes Anhaften der Lagen aus Aluminiumoxid auf den Lagen aus TiAIN und dadurch eine verlängerte Standzeit.

Die Aufgabe wird weiter durch die Verwendung eines Schneidwerkzeugs mit den oben beschriebenen Eigenschaften für Schneidplatten oder Sonderwendeschneidplatten in Kurbelwellenfräsen oder Nockenwellenfräsen gelöst.

Ein Schneidwerkzeug ist beim Fräsen von Kurbelwellen hohen Temperaturen und hohen Geschwindigkeiten ausgesetzt, da die Maschinenauslastung besonders hoch ist. Dies erfordert eine besonders hohe Temperaturwechselbeständigkeit des Schneidwerkzeugs, die eine hohe Kammrissfestigkeit bedingt.

Es hat sich überraschenderweise gezeigt, dass die erfindungsgemäße Kombination aus einem Grundkörper, der aus einem Hartmetall besteht, welches 5 bis 8 Gew.-% Co, 0 bis 2 Gew.-% TaC, 0 bis 1 Gew.-% NbC und 89 bis 95 Gew.-% WC aufweist, wobei WC eine mittlere Korngröße von 1 bis 5 µm aufweist, und einer Beschichtung, die mindestens eine erste Lage aus TiAIN mit einer Schichtdicke von 1 bis 5 µm und eine zweite Lage aus Aluminiumoxid mit einer Schichtdicke von 1 bis 4 µm aufweist, wobei die Beschichtung weiter auf der zweiten Lage aus Aluminiumoxid zusätzlich n alternierend übereinander aufgebrachte Lagen aus TiAIN und Lagen aus Aluminiumoxid mit jeweils einer Schichtdicke von 0,1 bis 0,5 µm umfasst, wobei n sich auf jede einzelne Lage bezieht und eine gerade Zahl von 0 bis 10 ist, wobei die Gesamtschichtdicke der Beschichtung 2 bis 16 µm beträgt und die Beschichtung im PVD-Verfahren erzeugt wird, eine besonders gute Resistenz gegenüber thermischer und mechanischer Wechselbeanspruchung, die beim Fräsen von Kurbelwellen und Nockenwellen auftritt, aufweist.

Weitere Vorteile, Merkmale und Ausführungsformen der vorliegenden Erfindung werden anhand der nachfolgenden Beispiele erläutert.

### Beispiel 1:

In einer PVD-Beschichtungsanlage Hauzer HTC1000 wurde ein Schneidwerkzeug aus 8 Gew.-% Co, 1,15 Gew.-% TaC, 0,27 Gew. % NbC und 90,58 Gew.-% WC mit einer siebenlagigen Beschichtung versehen:
1. TiAIN (Verhältnis Ti:Al von 33:67 at%) mit einer Schichtdicke von 3 µm im Lichtbogen abgeschieden
2. Aluminiumoxid mit einer Schichtdicke von 0,6 µm im reaktiven Magnetron abgeschieden
3. TiAIN (Verhältnis Ti:Al von 33:67 at%) mit einer Schichtdicke von 0,3 µm im Lichtbogen abgeschieden
4. Aluminiumoxid mit einer Schichtdicke von 0,1 µm im reaktiven Magnetron abgeschieden
5. TiAIN (Verhältnis Ti:Al von 33:67 at%) mit einer Schichtdicke von 0,3 µm im Lichtbogen abgeschieden
6. Aluminiumoxid mit einer Schichtdicke von 0,1 µm im reaktiven Magnetron abgeschieden
7. ZrN mit einer Schichtdicke von 0,2 µm im Lichtbogen abgeschieden

Vor dem Beschichten wurde das Substrat in Alkohol und vor dem Abscheiden der Lagen in der Vakuumkammer mit Ar-Ionenbeschuss zusätzlich gereinigt.

### Abscheidung der Lagen:

### 1., 3. und 5. Lage:

Die Abscheidung von TiAIN erfolgte im Lichtbogen mit 65 A Verdampferstrom pro Quelle bei 3 Pa Stickstoff und einer Biasspannung im DC Modus von 40 V und einer Temperatur von ca. 550 °C.

### 2., 4. und 6. Lage

Die Abscheidung von Aluminiumoxid erfolgte im reaktiven Magnetron mit spezifischer Kathodenleistung von ca. 7 W/cm² bei 0,5 Pa Ar und Sauerstoff als Reaktivgas (Fluss ca. 80 sscm), bei einer bipolar gepulsten Biasspannung (70 kHz) von 150 V und einer Temperatur von ca. 550 °C.

### 7. Lage

ZrN wurde im Lichtbogen mit 65 A Verdampferstrom pro Quelle abgeschieden, bei 3 Pa Stickstoff und einer Biasspannung im DC Modus von 40 V und einer Temperatur von ca. 550 °C.

### Beispiel 2 - Vergleichsbeispiel:

Zum Vergleich wurde auf ein Substrat gemäß Beispiel 1 eine herkömmliche CVD-Beschichtung aufgebracht. Die Beschichtung bestand aus folgenden Lagen:
1. TiCN mit einer Schichtdicke von 5 µm im mtCVD-Verfahren aufgebracht
2. αAl₂O₃ mit einer Schichtdicke von 4 µm im Hochtemperatur-CVD-Verfahren bei einer Temperatur von mehr als 1000 °C aufgebracht.

Das Aufbringen erfolgte gemäß einem Standard-Protokoll für thermische CVD. Es handelt sich dabei um ein Schneidwerkzeug für Kurbelwellenfräsen und Nockenwellenfräsen, wie es derzeit im Handel erhältlich ist.

### Versuchsdurchführung:

In einem Fräsversuch an einem Werkstück aus 25MnCrSi VB6 - Stahl, bei welchem Kurbelwellen fertiggestellt wurden, wurden die Schneidwerkzeuge aus Beispiel 1 mit denen des Beispiels 2 verglichen.

Es wurde mit einer Schnittgeschwindigkeit v_{c} von 146 m/min, einem Zahnvorschub f_{z} zwischen 0,12 mm und 0,18 mm gefräst. Die Fräsbearbeitung erfolgte trocken.

### Standzeiten:

Mit den erfindungsgemäßen Schneidwerkzeugen aus Beispiel 1 konnten bis zum Standzeitende mehr Kurbelwellen gefräst werden als mit den Vergleichswerkzeugen. Das Standzeitende definiert sich hier nach der Einhaltung der Maßhaltigkeit am Bauteil und der Spänebildung. Bei einer vorgegebenen Abweichung von den am Bauteil gewünschten Maßen ist das Standzeitende erreicht.

| | Kurbelwellen |
|---|---|
| Beispiel 1 | 704 |
| Beispiel 2 | 581 |

## Patentansprüche

1. Schneidwerkzeug mit einem Grundkörper und einer darauf aufgebrachten mehrlagigen Beschichtung, **dadurch gekennzeichnet, dass**
der Grundkörper aus einem Hartmetall besteht, welches aus
- 5 bis 8 Gew.-% Co, 0 bis 2 Gew.-% TaC, 0 bis 1 Gew.-% NbC und 89 bis 95 Gew.-% WC mit einer mittleren Korngröße von 1 bis 5 µm besteht,
und die Beschichtung
- eine erste Lage aus TiAIN mit einer Schichtdicke von 1 bis 5 µm und
- eine zweite Lage aus Aluminiumoxid mit einer Schichtdicke von 1 bis 4 µm aufweist,
und die Beschichtung weiter auf der zweiten Lage aus Aluminiumoxid zusätzlich
- n alternierend übereinander aufgebrachte Lagen aus TiAIN und Lagen aus Aluminiumoxid mit jeweils einer Schichtdicke von 0,1 bis 0,5 µm umfasst, wobei n sich auf jede einzelne Lage bezieht und eine gerade Zahl von 0 bis 10 ist,
wobei die Gesamtschichtdicke der Beschichtung 2 bis 16 µm beträgt und die Beschichtung im PVD-Verfahren erzeugt ist.

2. Schneidwerkzeug gemäß Anspruch 1, **dadurch gekennzeichnet, dass** die Beschichtung eine äußere Lage aus ZrN mit einer Schichtdicke von 0,1 bis 1 µm aufweist.

3. Schneidwerkzeug gemäß einem der vorangehenden Ansprüche, **dadurch gekennzeichnet, dass** das Werkzeug Spanflächen, Schneidkanten und Freiflächen aufweist und nur die Beschichtung an den Freiflächen eine äußere Lage aus ZrN aufweist.

4. Schneidwerkzeug gemäß einem der vorangehenden Ansprüche, **dadurch gekennzeichnet, dass** der Grundkörper aus einem Hartmetall besteht, welches 6 bis 8 Gew.-% Co, 1 bis 2 Gew.-% TaC, 0,2 bis 0,3 Gew. % NbC und als Rest WC aufweist.

5. Schneidwerkzeug gemäß einem der vorangehenden Ansprüche, **dadurch gekennzeichnet, dass** der Grundkörper WC mit einer mittleren Korngröße von 2 bis 3 µm umfasst.

6. Schneidwerkzeug gemäß einem der vorangehenden Ansprüche, **dadurch gekennzeichnet, dass** die erste Lage aus TiAIN eine Schichtdicke von 2 bis 4 µm aufweist und/oder die zweite Lage aus Aluminiumoxid eine Schichtdicke von 1 bis 2 µm aufweist.

7. Schneidwerkzeug gemäß einem der vorangehenden Ansprüche, **dadurch gekennzeichnet, dass** die zusätzlichen übereinander alternierend aufgebrachten Lagen aus TiAIN und Lagen aus Aluminiumoxid eine Schichtdicke von 0,1 bis 0,3 µm aufweisen.

8. Schneidwerkzeug gemäß einem der vorangehenden Ansprüche, **dadurch gekennzeichnet, dass** n = 2 oder n = 4 oder n = 6 ist.

9. Schneidwerkezeug gemäß einem der vorangehenden Ansprüche, **dadurch gekennzeichnet, dass** die Gesamtdicke der Beschichtung 2 bis 8 µm beträgt.

10. Schneidwerkzeug gemäß einem der Ansprüche 2 bis 9, **dadurch gekennzeichnet, dass** die Beschichtung unter der äußeren Lage aus ZrN eine Lage aus substöchiometrischem ZrN₁₋ₓ aufweist, wobei x 0,01 bis 0,1 beträgt und wobei die Schichtdicke der Lage zwischen 0,001 und 0,1 µm beträgt.

11. Schneidwerkzeug gemäß einem der vorangehenden Ansprüche, **dadurch gekennzeichnet, dass** das atomare Verhältnis von AI zu Ti in den aus TiAIN bestehenden Lagen von 60:40 bis 70:30 und bevorzugt 67:33 beträgt.

12. Verwendung eines Schneidwerkzeugs gemäß einem der Ansprüche 1 bis 11 für Schneidplatten oder Sonderwendeschneidplatten in Kurbelwellenfräsen oder Nockenwellenfräsen.

## Claims

1. A cutting tool comprising a main body and a multi-layer coating applied thereto, **characterised in that**
the main body comprises a hard metal which
- comprises 5 to 8% by weight of Co, 0 to 2% by weight of TaC, 0 to 1% by weight of NbC and 89 to 95% by weight of WC with a mean grain size of 1 to 5 µm,
and the coating has
- a first layer of TiAIN having a layer thickness of 1 to 5 µm, and
- a second layer of aluminium oxide having a layer thickness of 1 to 4 µm,
and the coating further additionally includes on the second layer of aluminium oxide
- n alternately mutually superposedly applied layers of TiAIN and layers of aluminium oxide respectively having a layer thickness of 0.1 to 0.5 µm, wherein n relates to each individual layer and is an even number of 0 to 10,
wherein the total layer thickness of the coating is 2 to 16 µm and the coating is produced in the PVD process.

2. A cutting tool according to claim 1 **characterised in that** the coating has an outer layer of ZrN having a layer thickness of 0.1 to 1 µm.

3. A cutting tool according to one of the preceding claims **characterised in that** the tool has rake surfaces, cutting edges and relief surfaces and only the coating at the relief surfaces has an outer layer of ZrN.

4. A cutting tool according to one of the preceding claims **characterised in that** the main body comprises a hard metal which has 6 to 8% by weight of Co, 1 to 2% by weight of TaC, 0.2 to 0.3% by weight of NbC and WC as the balance.

5. A cutting tool according to one of the preceding claims **characterised in that** the main body includes WC having a mean grain size of 2 to 3 µm.

6. A cutting tool according to one of the preceding claims **characterised in that** the first layer of TiAIN has a layer thickness of 2 to 4 µm and/or the second layer of aluminium oxide has a layer thickness of 1 to 2 µm.

7. A cutting tool according to one of the preceding claims **characterised in that** the additional alternately mutually superposedly applied layers of TiAIN and layers of aluminium oxide have a layer thickness of 0.1 to 0.3 µm.

8. A cutting tool according to one of the preceding claims **characterised in that** n = 2 or n = 4 or n = 6.

9. A cutting tool according to one of the preceding claims **characterised in that** the total thickness of the coating is 2 to 8 µm.

10. A cutting tool according to one of claims 2 to 9 **characterised in that** the coating has under the outer layer of ZrN a layer of substoichiometric ZrN₁₋ₓ, wherein x is 0.01 to 0.1 and wherein the layer thickness of the layer is between 0.001 and 0.1 µm.

11. A cutting tool according to one of the preceding claims **characterised in that** the atomic ratio of Al to Ti in the layers comprising TiAIN is from 60:40 to 70:30 and preferably 67:33.

12. Use of a cutting tool according to one of claims 1 to 11 for cutting inserts or special indexable cutting inserts in crankshaft milling cutters or camshaft milling cutters.

## Revendications

1. Outil de coupe ayant un corps de base sur lequel est appliqué un revêtement multicouche, **caractérisé en ce que**
le corps de base est constitué d'un métal dur qui est constitué
- de 5 à 8 % en poids de Co, de 0 à 2 % en poids de TaC, de 0 à 1 % en poids de NbC et de 89 à 95 % en poids de WC, avec une taille de grain moyenne comprise entre 1 et 5 µm,
et le revêtement présente
- une première couche de TiAIN avec une épaisseur de couche de 1 à 5 µm, et
- une seconde couche d'oxyde d'aluminium avec une épaisseur de couche de 1 à 4 µm,
et le revêtement comprenant en outre sur la seconde couche d'oxyde d'aluminium
- n couches de TiAIN et couches d'oxyde d'aluminium supplémentaires superposées en alternance, chacune d'une épaisseur de couche de 0,1 à 0,5 µm, dans lequel n fait référence à chaque couche individuelle et est un nombre pair de 0 à 10,
dans lequel l'épaisseur totale de couche du revêtement est de 2 à 16 µm et le revêtement est formé par un procédé de dépôt chimique en phase vapeur, PVD.

2. Outil de coupe selon la revendication 1, **caractérisé en ce que** le revêtement possède une couche externe de ZrN avec une épaisseur de couche de 0,1 à 1 µm.

3. Outil de coupe selon l'une des revendications précédentes, **caractérisé en ce que** l'outil présente des surfaces d'attaque, des arêtes de coupe et des zones ouvertes et seul le revêtement sur les zones ouvertes présente une couche externe de ZrN.

4. Outil de coupe selon l'une des revendications précédentes, **caractérisé en ce que** le corps de base est constitué d'un métal dur comportant de 6 à 8 % en poids de Co, de 1 à 2 % en poids de TaC, de 0,2 à 0,3 % en poids de NbC, et le reste de WC.

5. Outil de coupe selon l'une des revendications précédentes, **caractérisé en ce que** le corps de base comprend du WC avec une taille de grain moyenne de 2 à 3 µm.

6. Outil de coupe selon l'une des revendications précédentes, **caractérisé en ce que** la première couche de TiAIN a une épaisseur de couche de 2 à 4 µm et/ou la seconde couche d'oxyde d'aluminium a une épaisseur de couche de 1 à 2 µm.

7. Outil de coupe selon l'une des revendications précédentes, **caractérisé en ce que** les couches de TiAIN et les couches d'oxyde d'aluminium supplémentaires superposées en alternance ont une épaisseur de couche de 0,1 à 0,3 µm.

8. Outil de coupe selon l'une des revendications précédentes, **caractérisé en ce que** n = 2 ou n = 4 ou n = 6.

9. Outil de coupe selon l'une des revendications précédentes, **caractérisé en ce que** l'épaisseur totale du revêtement est de 2 à 8 µm.

10. Outil de coupe selon l'une des revendications 2 à 9, **caractérisé en ce que** le revêtement, sous la couche externe de ZrN, présente une couche de ZrN₁₋ₓ sous-stoechiométrique, dans lequel x est de 0,01 à 0,1 et dans lequel l'épaisseur de couche de la couche est entre 0,001 et 0,1 µm.

11. Outil de coupe selon l'une des revendications précédentes, **caractérisé en ce que** le rapport atomique d'Al à Ti dans les couches constituées de TiAIN est de 60:40 à 70:30, et de préférence de 67:33.

12. Utilisation d'un outil de coupe selon l'une des revendications 1 à 11 pour des plaquettes de coupe ou des plaquettes de coupe réversibles spéciales dans des fraiseuses de vilebrequin ou des fraiseuses d'arbre à cames.
